# EUROPEAN PATENT APPLICATION

(11) **EP 4 757 554 A1**
(43) Date of publication of application: **10.06.2026**
(21) Application number: 24847893.5
(22) Date of filing: 27.06.2024
(51) Int. Cl.: H10K 50/854

(54) **DISPLAY PANEL AND DISPLAY APPARATUS**

(30) Priority: 01.08.2023 CN 202310957505
(71) Applicant: HKC CORPORATION LIMITED, Shenzhen, Guangdong 518000 (CN)
(72) Inventor: LI, Jing, Shenzhen, Guangdong 518000 (CN); YUAN, Haijiang, Shenzhen, Guangdong 518000 (CN)
(74) Representative: Studio Torta S.p.A.
(86) International application number: PCT/CN2024/101883
(87) International publication number: WO 2025/025932

(57) **Abstract**

The present application relates to a display panel (10) and a display apparatus. The display panel (10) comprises a photosensitive display region (12) corresponding to a photosensitive element. The photosensitive display region (12) comprises a plurality of regularly arranged display pixel regions (120), and light-transmitting regions (121) located between adjacent display pixel regions (120). The light-transmitting regions (121) and the display pixel regions (120) are arranged spaced apart from each other. Each light-transmitting region (121) comprises: a main light-transmitting region (1210), which is in the shape of a rounded rectangle; and compensating light-transmitting regions (1211), which are formed at rounded corners of the main light-transmitting region (1210) and are spaced apart from the main light-transmitting region (1210), wherein the side of each compensating light-transmitting region (1211) that is close to a rounded corner has a right-angled corner. In the solution, by means of designing the main light-transmitting region (1210) in the shape of a rounded rectangle, the phenomenon of light diffraction can be alleviated; moreover, by means of forming the compensating light-transmitting regions (1211) at the rounded corners of the main light-transmitting region (1210), and providing the right-angled corner on the side of each compensating light-transmitting region (1211) that is close to a rounded corner of the main light-transmitting region (1210), an image captured by a photosensitive element (20) is more realistic, thereby improving the imaging effect of the photosensitive element (20).

## Description

### CROSS-REFERENCE TO RELATED APPLICATIONS

The present application claims priority to Chinese patent application No. 202310957505.6, titled "Display Panel and Display Device", filed on August 1, 2023, the entire contents of which are incorporated herein by reference.

### TECHNICAL FIELD

This application belongs to the field of display technology, particularly relates to a display panel and a display device.

### BACKGROUND

Due to the influence of front cameras, currently, the mainstream screens in the market have various irregular screens, including notch screens, teardrop screens, and punch hole screens. These irregular structures affect the aesthetics of the screen to a certain extent. Mobile phones with pop-up cameras or sliding cameras can achieve a true full-screen display. However, pop-up cameras and sliding cameras not only incur high costs but also have great difficulties in mechanical design, and their shock resistance capabilities need to be significantly improved. Therefore, the under-screen camera is the optimal full-screen solution that takes both cost and performance into account, but the imaging effect of existing under-screen cameras is poor.

### SUMMARY

The present application aims to provide a display panel and a display device, which can improve the imaging effect of the photosensitive element.

A first aspect of the present application provides a display panel which includes a photosensitive display region corresponding to a photosensitive element;
the photosensitive display region includes a plurality of display pixel regions provided in a regular manner and light-transmitting regions located between adjacent display pixel regions;
light-transmitting regions are provided at intervals with the plurality of the display pixel regions;
each light-transmitting region includes:
   a main light-transmitting region of a rounded rectangle;
   a compensation light-transmitting region, formed at a rounded corner of the main light-transmitting region and having a gap with the main light-transmitting region; and
   a side of the compensation light-transmitting region close to the rounded corner has a right-angle corner.

A second aspect of the present application provides a display device, which includes the display panel as described in any one of the above items and a driving chip connected to the display panel.

In addition, the solution of the present application also includes a display device. Since the main light-transmitting region, the compensation light-transmitting region, and the fact that the compensation light-transmitting region all are provided with a right-angle corner, the imaging effect of the photosensitive element is improved, and thus the imaging effect of the display device can be enhanced.

Other characteristics and advantages of the present application will become obvious through the following detailed description, or will be learned partly through the practice of the present application.

It should be understood that the above general description and the following detailed description are merely exemplary and explanatory, and shall not limit the present application.

### BRIEF DESCRIPTION OF THE DRAWINGS

The accompanying drawings here are incorporated into the specification and form a part of the specification, showing the embodiments in accordance with the present application, and are used together with the specification to explain the principles of the present application. Obviously, the accompanying drawings in the following description are only some embodiments of the present application. For those skilled in the art, other accompanying drawings can be obtained according to these accompanying drawings without creative efforts.
FIG. 1 is a schematic structural view of the display panel provided in first embodiment, second embodiment or third embodiment of the present application.
FIG. 2 is a schematic layout diagram of the main light-transmitting region and the rectangular compensation light-transmitting region provided in first embodiment and third embodiment of the present application.
FIG. 3 is a schematic structural view of the photosensitive element being provided under the display panel, and the light-transmitting hole in the main light-transmitting region or the compensation light-transmitting region being not filled with light-transmitting material, in the first embodiment, the second embodiment or the third embodiment of the present application.
FIG. 4 is a schematic structural view of the photosensitive element being provided under the display panel, and the light-transmitting hole in the main light-transmitting region/compensation light-transmitting region being filled with light-transmitting material, in the first embodiment, the second embodiment or the third embodiment of the present application.
FIG. 5 is a schematic structural view of the photosensitive element being provided under the display panel, and the light-transmitting hole in the main light-transmitting region/compensation light-transmitting region being opened to the planarization layer and filled with light-transmitting material, in the first embodiment, the second embodiment or the third embodiment of the present application.
FIG. 6 is a schematic structural view of the photosensitive element being provided under the display panel, and the light-transmitting hole in the main light-transmitting region/compensation light-transmitting region being opened to the planarization layer, in the first embodiment, the second embodiment or the third embodiment of the present application.
FIG. 7 is a schematic structural view of the photosensitive element being provided under the display panel, and a convex lens being provided in the main light-transmitting region/compensation light-transmitting region, in the first embodiment, the second embodiment or the third embodiment of the present application.
FIG. 8 is a schematic structural view of the photosensitive element being provided under the display panel, and a light-transmitting material being coated on the first inorganic encapsulation layer, in the first embodiment, the second embodiment or the third embodiment of the present application.
FIG. 9 is a schematic structural view of the photosensitive element being provided under the display panel, and the light-transmitting material after exposure and development, in the first embodiment, the second embodiment or the third embodiment of the present application.
FIG. 10 is a schematic structural view of the photosensitive element being provided under the display panel, and the light-transmitting material after baking, in the first embodiment, the second embodiment or the third embodiment of the present application.
FIG. 11 is a schematic structural view of the photosensitive element being provided under the display panel, and a light-transmitting material being filled above the convex lens, in the first embodiment, the second embodiment or the third embodiment of the present application.
FIG. 12 is a schematic structural view of two sub-light-transmitting regions being provided in the compensation light-transmitting region, in the second embodiment or the third embodiment of the present application.

Reference number:
10, display panel; 11, normal display region; 12, photosensitive display region; 120, display pixel region; 1200, pixel unit; 1201, display sub-pixel; 121, light-transmitting region; 1210, main light-transmitting region; 1211, compensation light-transmitting region; 12110, sub-light-transmitting region; 1213, light-transmitting hole; 1214, light-transmitting material; 1215, convex lens; 122, display light-emitting part; 123, display anode; 124, display cathode; 13, substrate; 14, driving circuit layer; 15, planarization layer; 16, pixel definition layer; 160, pixel definition part; 161, pixel opening; 17, encapsulation layer; 170, first inorganic encapsulation layer; 171, organic encapsulation layer; 172, second inorganic encapsulation layer; 18, shielding layer; 19, color resist layer; 190, color resist part; 100, base substrate; 110, anti-reflection layer; 20, photosensitive element.

### DETAILED DESCRIPTION OF THE EMBODIMENTS

Now, the exemplary embodiments will be described more comprehensively with reference to the accompanying drawings. However, the exemplary embodiments can be implemented in various forms and should not be construed as being limited to the examples set forth herein; rather, these embodiments are provided so that this application will be more thorough and complete, and will fully convey the concept of the exemplary embodiments to those skilled in the art.

In addition, the described features, structures, or characteristics can be combined in any suitable manner in one or more embodiments. In the following description, numerous specific details are provided to give a thorough understanding of the embodiments of the present application. However, those skilled in the art will recognize that the technical solutions of the present application can be practiced without one or more of the specific details, or other methods, components, devices, steps, etc. can be adopted. In other cases, well-known methods, devices, implementations, or operations are not shown or described in detail to avoid obscuring various aspects of the present application.

The present application will be further described in detail below in combination with the accompanying drawings and specific embodiments. It should be noted here that the technical features involved in the various embodiments of the present application described below can be combined with each other as long as they do not conflict with each other. The embodiments described below with reference to the accompanying drawings are exemplary and are intended to explain the present application, and should not be construed as limiting the present application.

### The First Embodiment

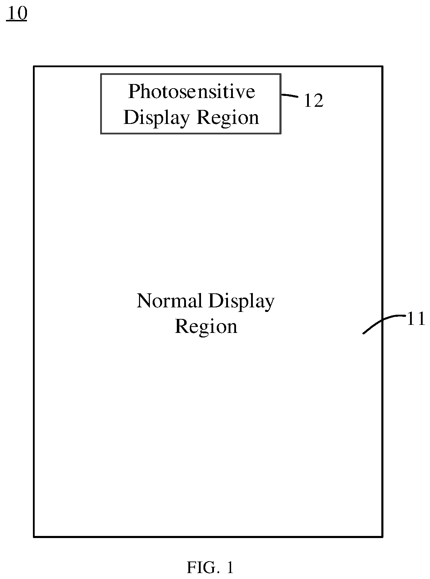

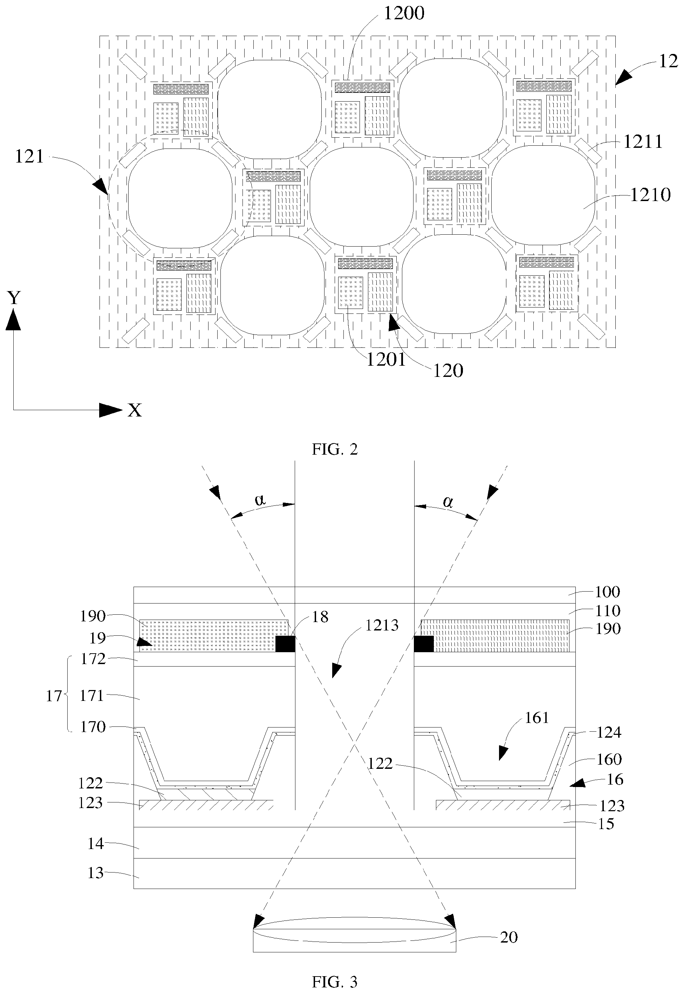

The first embodiment of the present application provides a display panel 10, and the display panel 10 can be an Organic Light Emitting Diode (OLED) display. As shown in FIG. 1, the display panel 10 includes a normal display region 11 and a photosensitive display region 12. The normal display region 11 is used to display normal images, and the photosensitive display region 12 corresponds to the photosensitive element 20. The photosensitive display region 12 includes a plurality of display pixel regions 120 provided in a regular pattern and light-transmitting regions 121 located between adjacent display pixel regions 120. The plurality of light-transmitting regions 121 are provided at intervals with the display pixel regions 120, as shown in FIG. 2.

It can be understood that since the light-transmitting regions 121 are adjacent to the display pixel regions 120 in the photosensitive display region 12, the number of light rays entering the photosensitive element 20 can be increased, and thus the photographing visual effect of the photosensitive element 20 under the display panel 10 can be improved.

In addition, as shown in FIG. 2, the display pixel region 120 includes a plurality of pixel units 1200, and each pixel unit 1200 includes a plurality of display sub-pixels 1201 with different colors. For example: red display sub-pixels, green display sub-pixels and blue display sub-pixels, etc. The plurality of display sub-pixels 1201 with different colors can be provided at intervals in the row direction, or can be provided in other ways, which can be specifically designed according to different embodiments. Each display sub-pixel 1201 includes a display light-emitting diode, and the display light-emitting diode includes a display light-emitting part 122, and the display light-emitting part 122 is formed on the organic light-emitting functional layer, as shown in FIG. 3.

It should be noted that the display light-emitting parts 122 can emit light of the same color, and the light emitted by the display light-emitting part 122 is discolored by the color resist part 190 described later, so as to realize the display sub-pixels 1201 of different colors. It can also be that each display light-emitting part 122 emits light of different colors, for example, emitting red light, green light and blue light. The display sub-pixel 1201 is of the color of the light it emits. That is, if the display light-emitting part 122 emits red light, it is a red display sub-pixel; if the display light-emitting part 122 emits green light, it is a green display sub-pixel; if the display light-emitting part 122 emits blue light, it is a blue display sub-pixel.

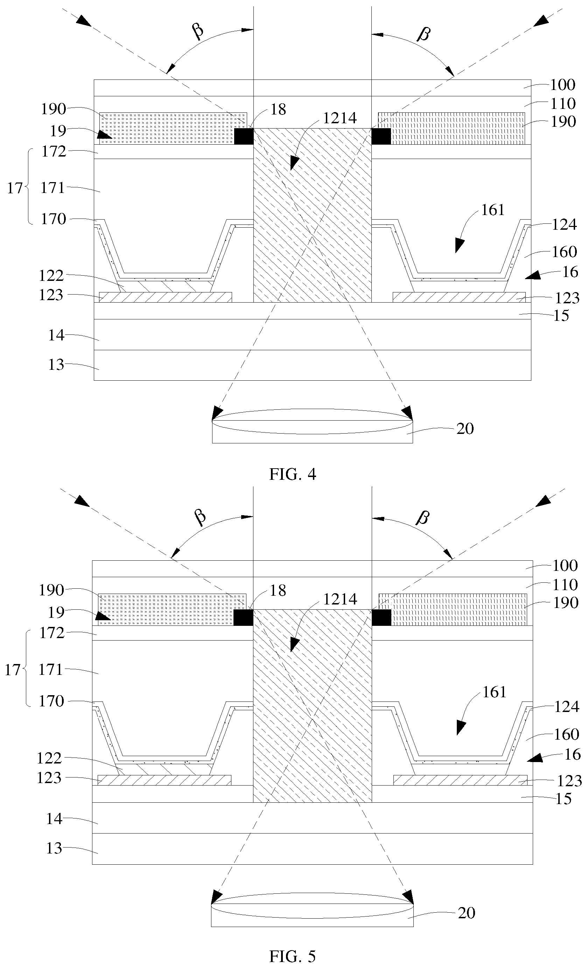

In the embodiment of the present application, as shown in FIG. 4 or FIG. 5, the display panel 10 includes a substrate 13, and a driving circuit layer 14, a planarization layer 15 and a pixel definition layer 16 formed on the substrate 13 in sequence. It can be understood that the substrate 13 can be a rigid substrate 13 made of glass, but it is not limited thereto, and it can also be a flexible substrate 13 made of materials such as polyimide (abbreviation). That is to say, the display device of the present application is not limited to a rigid and non-bendable panel, and can also be a flexible and bendable panel.

In addition, the driving circuit layer 14 can include circuit structures such as thin-film transistors and traces, etc., to drive the light-emitting diodes mentioned later to emit light, and will not be elaborated too much here. The planarization layer 15 is provided on a side of the driving circuit layer 14 away from the substrate 13 to planarize the driving circuit layer 14, so as to facilitate the arrangement of the light-emitting diodes mentioned later, so that the light-emitting diodes of the entire display panel 10 are on the same plane and the display effect is ensured.

As shown in FIG. 4 or FIG. 5, the pixel definition layer 16 can have a plurality of pixel openings 161 provided at intervals and pixel definition parts 160 located between adjacent pixel openings 161. In other words, the pixel definition layer 16 as a whole can be regarded as a grid-like hollow structural layer. The hollow region is the pixel opening 161 for forming pixels in this embodiment, and the non-hollow region is the pixel definition part 160 of this embodiment. It should be understood that the surface of the pixel definition part 160 away from the substrate 13 is a plane. For example, the pixel definition layer 16 can be made of materials such as Polyimide (PI).

In addition, the above display light-emitting diode also includes a display anode 123 and a display cathode 124. As shown in FIG. 4 or FIG. 5, the display anode 123 is provided on a side of the display light-emitting part 122 close to the substrate 13, and the display cathode 124 is provided on a side of the display light-emitting part 122 away from the substrate 13.

It should be understood that the display anodes 123 of display light-emitting diodes in the display panel 10 are provided at intervals from each other, so that each display light-emitting diode can be driven independently. The display cathodes 124 of display light-emitting diodes can be connected to each other to form a whole surface electrode, so as to reduce the processing cost.

The display anode 123 can include a first conductive layer, and the first conductive layer is formed on a side of the planarization layer 15 away from the driving circuit layer 14 and is located between the planarization layer 15 and the pixel definition layer 16. That is to say, in the process of manufacturing the display panel 10, the first conductive layer is first formed on the planarization layer 15, and then the pixel definition layer 16 is manufactured. The pixel definition part 160 covers an edge region of the first conductive layer. The edge region of the first conductive layer can be connected to the structures such as thin-film transistors in the driving circuit layer 14, and the pixel opening 161 exposes a middle region of the first conductive layer. The display light-emitting part 122 is located in the pixel opening 161 and is in contact with the middle region of the first conductive layer.

For example, the first conductive layer can be a multi-layer structure, that is, the first conductive layer can at least include a reflective layer and a high work function material layer stacked in sequence. The high work function material layer can include indium tin oxide (ITO), indium zinc oxide (IZO), zinc oxide (ZnO) or indium oxide (In₂O₃). The reflective layer can include silver (Ag). That is to say, the first conductive layer can be a multi-layer structure of ITO/Ag, but it is not limited thereto. The first conductive layer can also include a high work function material layer, a reflective layer and a high work function material layer stacked in sequence. For example, the first conductive layer can also be a multi-layer structure of ITO/Ag/ITO.

The display light-emitting part 122 can be located in the pixel opening 161. That is to say, when manufacturing the display panel 10, the pixel definition layer 16 can be manufactured first, and after the pixel definition layer 16 is manufactured, the display light-emitting part 122 is manufactured, so that the display light-emitting part 122 is formed in the pixel opening 161. For example, the display light-emitting part 122 can be formed in the pixel opening 161 by means of evaporation and plating.

It can be understood that the number of the display light-emitting parts 122 is the same as that of the pixel openings 161 and they correspond one by one.

It should be understood that the display light-emitting part 122 can include a hole injection layer, a hole transport layer, an organic light-emitting material layer, an electron transport layer and an electron injection layer stacked in sequence. The hole injection layer is in contact with the display anode 123, and the electron injection layer is in contact with the display cathode 124, but it is not limited thereto. The display light-emitting part 122 can also only include a hole transport layer, a light-emitting material layer and an electron transport layer, or other structures, which can be determined according to actual needs.

The display cathode 124 can be formed after the display light-emitting part 122 is formed and is in contact with the display light-emitting part 122. The display cathode 124 can include a low work function material layer containing Li, Ca, LiF/Ca, LiF/Al, Al, Mg, Ag, Pt, Pd, Ni, Au, Nd, Ir, Cr, BaF2, Ba, compounds or mixtures thereof. For example, the display cathode 124 can include a low work function material layer made of a mixture of Ag and Mg.

It is worth mentioning that the display cathode 124 in the normal display region 11 and the display cathode 124 in the photosensitive display region 12 can be designed as a whole surface, or the display cathodes 124 in these two regions can be separated from each other, that is, designed separately, and connected by means of metal traces.

In addition, as shown in FIG. 4 or FIG. 5, the display panel 10 also includes an encapsulation layer 17, and the encapsulation layer 17 is located on the side of the display light-emitting diode away from the substrate 13. The encapsulation layer 17 includes a first inorganic encapsulation layer 170, an organic encapsulation layer 171 and a second inorganic encapsulation layer 172 stacked in sequence.

In the embodiment of the present application, as shown in FIG. 4 or FIG. 5, the display panel 10 adopts the color filter on encapsulation (COE) technology, that is, the display panel 10 also includes a shielding layer 18 and a color resist layer 19 formed on the second inorganic encapsulation layer 172. The color resist layer 19 includes a plurality of color resist parts 190 provided at intervals from each other, and adjacent color resist parts 190 are different colors. In order to avoid color mixing between adjacent color resist parts 190, the shielding layer 18 made of a light-shielding material is provided between adjacent color resist parts 190, and the orthographic projection of the color resist part 190 on the substrate 13 and the orthographic projection of the shielding layer 18 on the substrate 13 have an overlapping region, so as to avoid the color resist part 190 from falling off, to ensure the display effect.

Each display light-emitting diode corresponds to a color resist portion 190 of a specific light-emitting color. The color resist portion 190 can efficiently absorb the full wavelength of ambient light. The red (R), green (G), and blue (B) color resist portions 190 can ensure that 80% or more of the display light emitted by the display light-emitting portion 122 passes through. While further purifying the light, the color resist portion 190 can also effectively absorb light of other wavelengths in the ambient light that are not the corresponding primary colors. In this way, without using a circular polarizer, the reflection of ambient light by the display device can be reduced, so that the display has better contrast and more accurate and wider color performance.

Further, as shown in FIG. 4 or FIG. 5, the display panel 10 also includes a base substrate 100 and an anti-reflection layer 110. The anti-reflection layer 110 is provided on the sides of the color resist layer 19 and the shielding layer 18 away from the second inorganic encapsulation layer 172. That is, when manufacturing the color resist layer 19 and the shielding layer 18, the shielding layer 18 and the color resist layer 19 are first manufactured on the second inorganic encapsulation layer 172, and then the anti-reflection layer 110 is manufactured. The anti-reflection layer 110 can reduce the reflection intensity of external ambient light on the screen, and thus the polarizer of the display panel 10 can be eliminated. This not only reduces the overall thickness of the display panel 10 but also may increase the light-emitting rate, greatly increasing the light-emitting brightness and reducing the power consumption of the display panel 10. The base substrate 100 is covered on a side of the anti-reflection layer 110 away from the substrate 13 to cover the anti-reflection layer 110, and the light-emitting effect is improved.

In the embodiment of this application, within the photosensitive display region 12, there is a black region at the gap between the light-transmitting region 121 and the display pixel region 120. This black region is either a metal wiring region or the aforementioned shielding layer 18.

To increase the light transmittance at the photosensitive display region 12 and improve the imaging effect of the photosensitive element 20, the light-transmitting region 121 includes a main light-transmitting region 1210, as shown in FIG. 2.

As shown in FIG. 2, the main light-transmitting region 1210 is located between adjacent pixel units 1200. That is, adjacent pixel units 1200 can share this main light-transmitting region 1210. To better increase the light transmittance, the pixel units 1200 in adjacent rows are provided in a cross manner. That is, two pixel units 1200 in adjacent rows are in a shape like a letter Z. In other words, one main light-transmitting region 1210 can be surrounded by four pixel units 1200, and these four pixel units 1200 can share this main light-transmitting region 1210. It can also be understood that four main light-transmitting regions 1210 surround one pixel unit 1200. By increasing the number of main light-transmitting regions 1210 in the photosensitive display region 12, the amount of light entering the photosensitive element 20 is increased, thereby improving the imaging effect of the photosensitive element 20.

The main light-transmitting region 1210 can be a square or rectangular structure. To reduce or improve the light diffraction phenomenon, edge corners of the main light-transmitting region 1210 are designed as rounded corners. That is, the edge of the main light-transmitting region 1210 is of a rounded-rectangular or rounded-square structure.

It can be understood that the main light-transmitting region 1210 can also be designed as a circular or elliptical structure to improve the light diffraction phenomenon, which can be specifically designed according to different embodiments.

In addition, the photosensitive element 20 is located below the substrate 13. Light enters the photosensitive element 20 from the main light-transmitting region 1210 to achieve the imaging effect.

To increase the light transmittance, the parts of the planarization layer 15, the pixel definition layer 16, and the encapsulation layer 17 located in the main light-transmitting region 1210 are light-transmitting parts. The refractive index of the light-transmitting part of at least one of the planarization layer 15, the pixel definition layer 16, and the encapsulation layer 17 is greater than that of other film layers surrounding the light-transmitting part. Due to different refractive indexes, the path of the light is changed, enabling light from a large viewing angle to enter the photosensitive element 20, which increases the amount of light entering the photosensitive element 20, thereby increasing the collection brightness during the shooting of the photosensitive element 20 and improving the shooting brightness of the photosensitive element 20.

It can be understood that the light-transmitting part can be composed of a light-transmitting hole 1213 and a light-transmitting material 1214. That is, the light-transmitting hole 1213 is opened and filled with the light-transmitting material 1214 on the planarization layer 15, the pixel definition layer 16, and the encapsulation layer 17.

In addition, the light-transmitting hole 1213 can be opened on one, two, or all three of the planarization layer 15, the pixel definition layer 16, and the encapsulation layer 17.

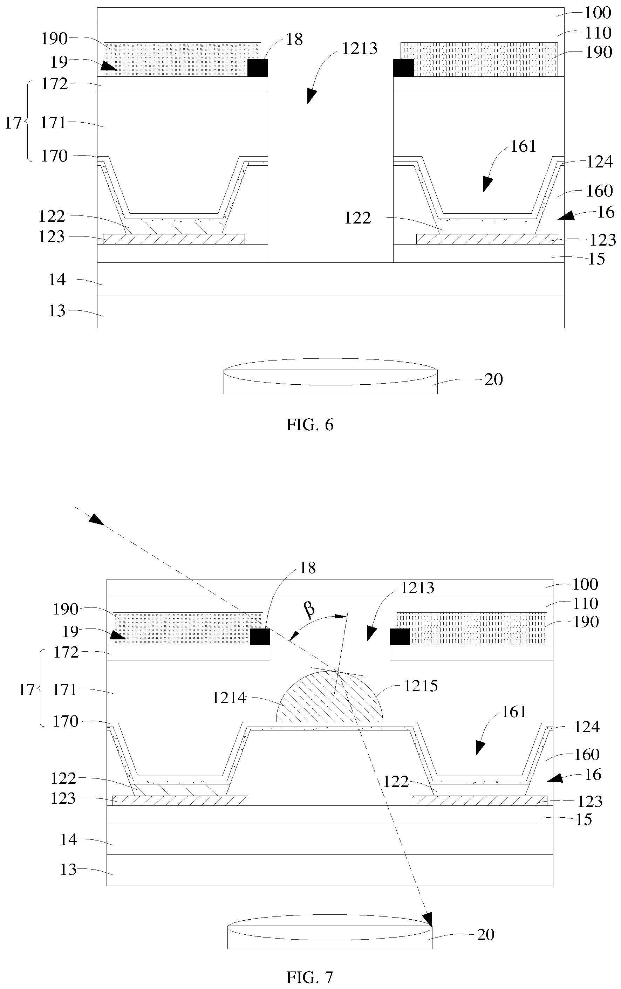

For example, the light-transmitting hole 1213 is opened at the main light-transmitting region 1210, as shown in FIG. 3 or FIG. 6, and the light-transmitting hole 1213 is filled with the light-transmitting material 1214, as shown in FIG. 4. The refractive index of the light-transmitting material 1214 is greater than that of the film layers surrounding the light-transmitting material 1214, so that light from a wider viewing angle can be refracted into the photosensitive element 20 through the refracting material. That is, as shown in FIG. 3, originally only light at the critical angle α could pass through the main light-transmitting region 1210 and enter the photosensitive element 20 in a straight line. As shown in FIG. 4 or FIG. 5, now light at the critical angle β (β > α) can also enter the photosensitive element 20 through the refraction of the light-transmitting material 1214. Then, light between the critical angle α and the critical angle β can also be refracted into the photosensitive element 20 through the light-transmitting material 1214, increasing the amount of light that can enter the main light-transmitting region 1210, and thus increasing the amount of light entering the photosensitive element 20, further increasing the collection brightness during the shooting of the photosensitive element 20 and improving the shooting brightness of the photosensitive element 20.

It can be understood that the critical angle α /critical angle β means that the light just falls on the edge of the photosensitive element 20, that is, the light can enter the photosensitive element 20. When the angle is greater than the critical angle α /critical angle β, the light will fall outside the photosensitive element 20, and the photosensitive element 20 will not collect the light.

To prevent the light-transmitting material 1214 from affecting the display effect, as shown in FIG. 3 or FIG. 6, the light-transmitting hole 1213 can be opened between adjacent display sub-pixels 1201 and has no overlapping region with the display light-emitting part 122. For example, the main light-transmitting region 1210 corresponds to the pixel definition part 160. That is, the light-transmitting hole 1213 is opened at the pixel definition part 160 and at the position in the vertical direction corresponding to the pixel definition part 160, and the light-transmitting hole 1213 is filled with the light-transmitting material 1214.

For example, the light-transmitting holes 1213 are opened at the pixel definition part 160, the shielding layer 18 corresponding to the pixel definition part 160, the second inorganic encapsulation layer 172, the organic encapsulation layer 171, the first inorganic encapsulation layer 170, and the display cathode 124, and then the light-transmitting holes 1213 are filled with the light-transmitting material 1214.

In some optional embodiments, as shown in FIG. 3, the pixel definition part 160, the shielding layer 18 corresponding to the pixel definition part 160, the second inorganic encapsulation layer 172, the organic encapsulation layer 171, the first inorganic encapsulation layer 170, and the display cathode 124 all are opened with light-transmitting holes 1213. That is, an opening is made at the pixel definition part 160, and this opening can extend to the planarization layer 15 and expose part of the planarization layer 15. That is, after the light-transmitting hole 1213 penetrates the pixel definition part 160, no further extension, and only extends to the planarization layer 15.

In another optional embodiment, as shown in FIG. 6, the pixel definition part 160, the shielding layer 18 corresponding to the pixel definition part 160, the second inorganic encapsulation layer 172, the organic encapsulation layer 171, the first inorganic encapsulation layer 170, the display cathode 124, and the planarization layer 15 all opened with light-transmitting holes 1213. That is, an opening is made at the pixel definition part 160, and the bottom of this opening can be located in the planarization layer 15. That is, only a part of the opening is made in the planarization layer 15 without penetrating the planarization layer 15. The method of making a part of the opening in the planarization layer 15 can protect the metal wiring on the driving circuit layer 14. Of course, the bottom of the opening can also penetrate the planarization layer 15, that is, the opening exposes a part of the driving circuit layer 14. Compared with the method of making the opening only in the pixel definition part 160 and the method of making the part of the opening in the planarization layer 15, when the light-transmitting material 1214 is completely filled in the planarization layer 15, the region where the light is refracted can be larger and wider, so that light from a larger viewing angle can enter the photosensitive element 20 through the light-transmitting material 1214.

It should be noted that the opening of the light-transmitting hole 1213 can be carried out after the shielding layer 18 is manufactured. The shielding layer 18, the second inorganic encapsulation layer 172, the organic encapsulation layer 171, the first inorganic encapsulation layer 170, the display cathode 124, the pixel definition part 160, and the planarization layer 15 located at the main light-transmitting region 1210 are opened together to form the entire light-transmitting hole 1213. It can also be that the light-transmitting hole 1213 is opened when each corresponding layer is manufactured. That is, the light-transmitting hole 1213 is made when the planarization layer 15 is manufactured, and the light-transmitting hole 1213 is made when the pixel definition part 160 is manufactured, and so on. Until the shielding layer 18 is manufactured, the entire light-transmitting hole 1213 is completed, and the light-transmitting holes 1213 on all layer are all corresponding and connected to each other, so as to fill the light-transmitting material 1214 into the light-transmitting holes 1213 to ensure the light-transmitting effect.

Of course, the filling of the light-transmitting material 1214 can be carried out after each light-transmitting hole 1213 is made. For example, the light-transmitting material 1214 can be a mixture of high-refractive-index substances such as silicon nitride (SiN) and silicon oxide (SiO) with organic substances in different proportions, or a high-refractive-index organic film formed by organic analysis structures with different chain lengths and analysis structures.

For example, when the light-transmitting material 1214 is silicon nitride (SiN), its refractive index can reach 1.7 to 1.9, such as 1.7, 1.8, 1.9, etc.

As shown in FIG. 4 or FIG. 5, when the light-transmitting material 1214 is filled into the light-transmitting hole 1213, the light-transmitting material 1214 is surrounded by the pixel definition part 160, the display cathode 124, the encapsulation layer 17, and the shielding layer 18, and the refractive index of the light-transmitting material 1214 is greater than that of other film layers surrounding the light-transmitting material 1214. That is, when the light-transmitting hole 1213 is only opened in the pixel definition part 160, the display cathode 124, the encapsulation layer 17, and the shielding layer 18, the refractive index of the light-transmitting material 1214 is greater than that of the pixel definition part 160, that of the display cathode 124, that of the encapsulation layer 17, and that of the shielding layer 18. When the light-transmitting hole 1213 is opened to the planarization layer 15, the refractive index of this light-transmitting material 1214 is greater than that of the planarization layer 15.

In addition, the refractive index of the anti-reflection layer 110 located above the color resist layer 19 and the shielding layer 18 is 1.55. That is to say, the refractive index of the anti-reflection layer 110 is less than that of the light-transmitting material 1214. Moreover, the refractive indexes of the pixel definition part 160, the display cathode 124, the encapsulation layer 17, and the shielding layer 18 are also the same as that of the anti-reflection layer 110. That is, when the light-transmitting material 1214 is not filled, the light entering from the anti-reflection layer 110 will not be refracted but will enter the main light-transmitting region 1210 in a straight line.

It can be understood that after filling the light-transmitting material 1214, since the refractive indexes of the anti-reflection layer 110, the pixel definition part 160, the shielding layer 18, the encapsulation layer 17, and the display cathode 124 are all less than that of the light-transmitting material 1214, according to the law of refraction, the incident angle of the light is greater than the exit angle of the light. Thus, light from a large viewing angle can be refracted by the light-transmitting material 1214 onto the photosensitive element 20.

That is to say, the light with an angle smaller than the critical angle α can fall onto the photosensitive element 20 in the straight line when the light-transmitting material 1214 is not filled, and the light with an angle larger than the critical angle α cannot fall onto the photosensitive element 20 when the light-transmitting material 1214 is not filled. When the light-transmitting material 1214 is filled, the light with an angle larger than the critical angle α can be refracted into the photosensitive element 20 due to the different refractive indexes of the light-transmitting material 1214 and the film layers surrounding it, that is, the light-transmitting material 1214 can make the light with an angle between the critical angle α and the critical angle β also fall onto the photosensitive element 20, allowing more light to fall onto the photosensitive element 20 through refraction, increasing the light collection angle of the photosensitive element 20 during shooting, and thus increasing the shooting brightness and expanding the shooting viewing angle to obtain more realistic pictures.

In some embodiments, as shown in FIG. 7, a convex lens 1215 can be formed between the first inorganic encapsulation layer 170 and the organic encapsulation layer 171, and the convex surface of the convex lens 1215 is away from the organic light-emitting functional layer. The light will be refracted when passing through the convex lens 1215, and then the light can be introduced into the photosensitive element 20, enabling the photosensitive element 20 to obtain more light, expanding the collection viewing angle of the camera, increasing the collected content, and improving the shooting visual effect of the photosensitive element 20.

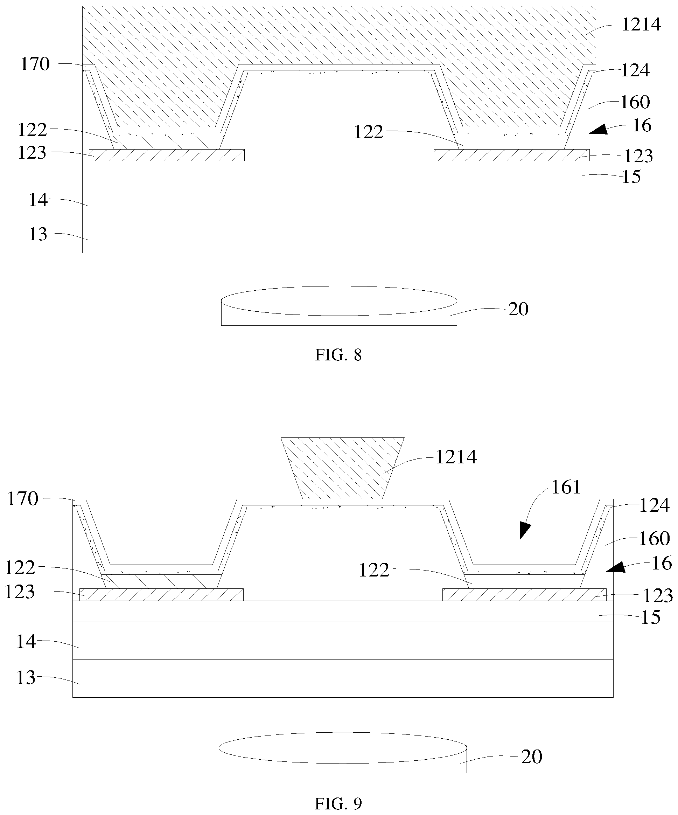

It can be understood that the convex lens 1215 can be made of the above-mentioned light-transmitting material 1214, that is, the structure of the convex lens 1215 is formed through coating, exposure, development, and baking. As shown in FIGS. 8, 9, and 10, for example, after the first inorganic encapsulation layer 170 is manufactured, the light-transmitting material 1214 is coated on the whole layer, or a high refractive index film layer is formed on the first inorganic encapsulation layer 170 by dropping similar to One Drop Filling (ODF), and then a patterned high refractive index film is formed through exposure and development, and finally the convex lens 1215 is formed through a certain baking process.

Since the light-transmitting material 1214 needs to be exposed, developed, and baked, in order to avoid damaging the display light-emitting part 122 during the manufacturing process of the convex lens 1215, the convex lens 1215 is provided between the first inorganic encapsulation layer 170 and the organic encapsulation layer 171. The organic encapsulation layer 171 can also play a planarization role, that is, the side of the organic encapsulation layer 171 away from the first inorganic encapsulation layer 170 is a plane.

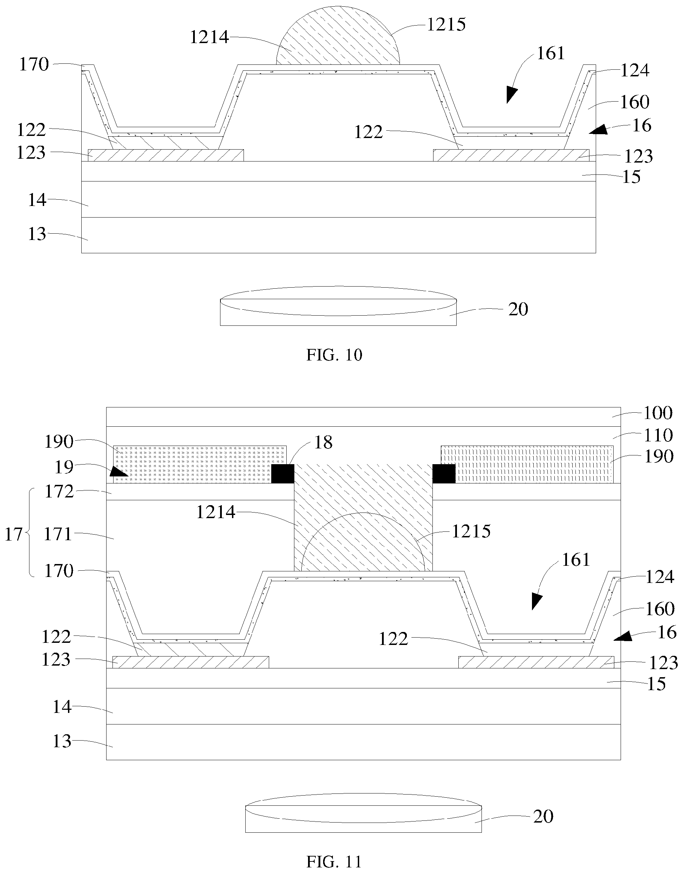

In other embodiments, as shown in FIG. 11, the light-transmitting material 1214 can be filled above and/or below the convex lens 1215 to ensure that more light can enter the photosensitive element 20 through refraction.

Furthermore, as shown in FIG. 2, in order to prevent the image captured by the photosensitive element 20 from being distorted or the picture from being rounded, the light-transmitting region 121 also includes a compensation light-transmitting region 1211. The compensation light-transmitting region 1211 is formed at the rounded corner of the main light-transmitting region 1210 and has a gap with the main light-transmitting region 1210, and the side of the compensation light-transmitting region 1211 close to the rounded corner has a right-angle corner.

It can be understood that the side of the compensation light-transmitting region 1211 close to the rounded corner having the right-angle corner can fill the rounded corner of the main light-transmitting region 1210, avoiding the image from being rounded and enabling the captured picture to better restore the captured content.

In addition, as shown in FIGS. 3 and 6, the compensation light-transmitting region 1211 can also adopt the same structure as that of the above-mentioned main light-transmitting region 1210, that is, the light-transmitting hole 1213 is opened at the compensation light-transmitting region 1211, and the light-transmitting hole 1213 is filled with the light-transmitting material 1214, thereby increasing the amount of light entering the photosensitive element 20.

For example, the light-transmitting hole 1213 can be opened at a position of the compensation light-transmitting region 1211 corresponding to the pixel definition part 160 and spaced apart from that of the light-transmitting hole 1213 of the main light-transmitting region 1210. That is, light-transmitting holes 1213 are opened on the shielding layer 18, the encapsulation layer 17, the display cathode 124, the pixel definition part 160, and the planarization layer 15 corresponding to the compensation light-transmitting region 1211, and the light-transmitting holes 1213 are filled with the light-transmitting material 1214. It can be understood that the light-transmitting materials 1214 of the main light-transmitting region 1210 and the compensation light-transmitting region 1211 can be the same or different, which can be specifically designed according to different embodiments. By adding the compensation light-transmitting region 1211, the amount of light entering the photosensitive element 20 can be increased, the brightness of the captured picture can be improved, the shooting visual effect can be enhanced, and the collected content can be increased. In addition, a convex lens 1215 can also be formed on the first inorganic encapsulation layer 170 and the organic encapsulation layer 171 within the compensation light-transmitting region 1211, and the convex lens 1215 in the compensation light-transmitting region 1211 is provided at intervals with the convex lens 1215 in the main light-transmitting region 1210. The compensation light-transmitting region 1211 can specifically refer to the design of the convex lens 1215 in the above-mentioned main light-transmitting region 1210, as shown in FIGS. 7, 10, and 11.

It is worth mentioning that the display cathodes 124 in the photosensitive display region 12 can be connected to each other through a transparent metal material, so as to realize one-key control of the opening and closing of the display cathodes 124.

Further, as shown in FIG. 2, adjacent light-transmitting regions 121 share the compensation light-transmitting region 1211 to save the space of the photosensitive display region 12 to arrange more pixel units 1200.

Furthermore, as shown in FIG. 2, the main light-transmitting region 1210 has a first straight side parallel to the first direction and a second straight side parallel to the second direction, and the first direction is perpendicular to the second direction. The compensation light-transmitting region 1211 is a right-angled rectangle, and the included angle between the straight side of the compensation light-transmitting region 1211 close to the rounded corner and the first straight side or the second straight side ranges from 30° to 60° . For example, it can be 30° , 45° , or 60° .

In an optional embodiment, the included angle between the straight side of the compensation light-transmitting region 1211 close to the rounded corner and the first straight side and the included angle between the straight side of the compensation light-transmitting region 1211 close to the rounded corner and the second straight side are 45° . At this time, a right-angle inflection point of the compensation light-transmitting region 1211 close to the first straight side is provided in a collinear manner with the first straight side; that is, the straight side of the compensation light-transmitting region 1211 is tangent to the rounded corner of the main light-transmitting region 1210, and the compensation light-transmitting region 1211 fills the rounded corner of the main light-transmitting region 1210, avoiding the four corners of the square picture from being rounded and ensuring the true restoration of the picture.

In another optional embodiment, the right-angle inflection point of the compensation light-transmitting region 1211 close to the first straight side is provided in a collinear manner with the first straight side, and the right-angle inflection point of the compensation light-transmitting region 1211 close to the second straight side is provided in a collinear manner with the second straight side to fill and compensate for the rounded corner of the main light-transmitting region 1210, thereby avoiding the four corners of the square picture from being rounded and ensuring the true restoration of the picture.

It is worth mentioning that the distance between the rectangular compensation light-transmitting region 1211 and the rounded corner and the distance between the rectangular compensation light-transmitting region 1211 and the pixel unit 1200 are greater than or equal to 3 µ m, such as 3 µ m, 4 µ m, 5 µ m, 6 µ m, 7 µ m, etc.

In the solution of the present application, by filling the light-transmitting material 1214 at the positions corresponding to the main light-transmitting region 1210 and the compensation light-transmitting region 1211, and the refractive index of the light-transmitting material 1214 is greater than that of the film layers surrounding the light-transmitting material 1214, the light from a large viewing angle can enter the photosensitive element 20 through refraction. That is to say, more light can enter the photosensitive element 20 through the light-transmitting material 1214, improving the shooting brightness of the photosensitive element 20 and the authenticity of the captured picture. In addition, in the solution of the present application, the main light-transmitting region 1210 is designed to have a rounded-rectangle structure to improve the light diffraction phenomenon, and the compensation light-transmitting region 1211 is formed at the rounded corner of the main light-transmitting region 1210. The side of the compensation light-transmitting region 1211 close to the rounded corner is provided with a right-angle corner to compensate and fill the rounded corner edge of the main light-transmitting region 1210, avoiding the square picture from being rounded, ensuring that the picture captured by the photosensitive element 20 is not distorted, and making the picture more realistically restored.

### The Second Embodiment

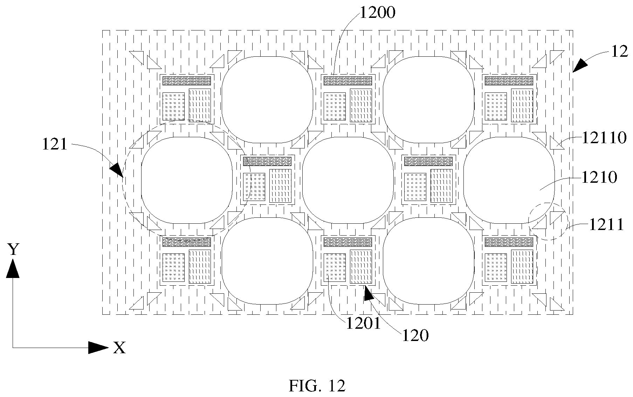

The difference between the second Embodiment of the present application and the first embodiment is as follows: as shown in FIG. 12, the compensation light-transmitting region 1211 includes at least two sub-light-transmitting regions 12110. The at least two sub-light-transmitting regions 12110 are provided at intervals, and the arrangement direction of the at least two sub-light-transmitting regions 12110 is in the same plane as and intersects with the first direction and the second direction. Each sub-light-transmitting region 12110 can be a right-angled triangle, and the acute angle of the sub-light-transmitting region 12110 ranges from 30° to 60° , for example, it can be 30° , 45° , or 60° . And the right-angle corners of adjacent sub-light-transmitting regions 12110 are close to the rounded corners of different main light-transmitting regions 1210, so that adjacent main light-transmitting regions 1210 can share this compensation light-transmitting region 1211.

In an optional embodiment, the acute angle of the sub-light-transmitting region 12110 is 45° ; one right-angle side of the sub-light-transmitting region 12110 is parallel to the first direction, and the other right-angle side is parallel to the second direction; and in adjacent sub-light-transmitting regions 12110: an oblique side of one sub-light-transmitting region 12110 is provided in a collinear manner with the inflection point of the right-angle corner of the other sub-light-transmitting region 12110.

For example, the main light-transmitting region 1210 has a square rounded-corner structure, the compensation light-transmitting region 1211 includes two sub-light-transmitting regions 12110, and the acute angle of the sub-light-transmitting region 12110 is 45° . The two sub-light-transmitting regions 12110 are provided along the extension direction of the diagonal of the main light-transmitting region 1210, that is, one right-angle side of the sub-light-transmitting region 12110 is parallel to the first direction, and the other right-angle side is parallel to the second direction. In one compensation light-transmitting region 1211, the oblique side of one sub-light-transmitting region 12110 is provided in a collinear manner with the inflection point of the right-angle corner of the other sub-light-transmitting region 12110. That is to say, the right angle of one sub-light-transmitting region 12110 faces the rounded corner position of the main light-transmitting region 1210, and the right angle of the other sub-light-transmitting region 12110 faces the rounded corner of the adjacent main light-transmitting region 1210 to compensate and fill the rounded corner of the main light-transmitting region 1210, avoiding the four corners of the square picture from being rounded and ensuring the shooting effect.

In another optional embodiment, the acute angle of the sub-light-transmitting region 12110 is 45° ; one right-angle side of the sub-light-transmitting region 12110 is parallel to the first direction, and the other right-angle side is parallel to the second direction; or in adjacent sub-light-transmitting regions 12110: the oblique side of one sub-light-transmitting region 12110 is provided in a collinear manner with the inflection point of the right-angle corner of the other sub-light-transmitting region 12110.

That is, the acute angle of the sub-light-transmitting region 12110 is 45° , one right-angle side of the sub-light-transmitting region 12110 is parallel to the first direction, and the other right-angle side is parallel to the second direction; in adjacent sub-light-transmitting regions, the oblique side of the sub-light-transmitting region 12110 and the inflection point of the right-angle corner of the other sub-light-transmitting region 12110 may not be provided in a collinear manner.

In yet another optional embodiment, the acute angle of the sub-light-transmitting region 12110 is 45° ; or one right-angle side of the sub-light-transmitting region 12110 is parallel to the first direction, and the other right-angle side is parallel to the second direction; or in adjacent sub-light-transmitting regions 12110: the oblique side of one sub-light-transmitting region 12110 is provided in a collinear manner with the inflection point of the right-angle corner of the other sub-light-transmitting region 12110.

That is, the acute angle of the sub-light-transmitting region 12110 is 45° , one right-angle side of the sub-light-transmitting region 12110 is not parallel to the first direction, the other right-angle side is not parallel to the second direction, and in adjacent sub-light-transmitting regions 12110: the oblique side of one sub-light-transmitting region 12110 and the inflection point of the right-angle corner of the other sub-light-transmitting region 12110 are not provided in a collinear manner.

In still another optional embodiment, the acute angle of the sub-light-transmitting region 12110 is 45° ; or one right-angle side of the sub-light-transmitting region 12110 is parallel to the first direction, and the other right-angle side is parallel to the second direction; and in adjacent sub-light-transmitting regions 12110: the oblique side of one sub-light-transmitting region 12110 is provided in a collinear manner with the inflection point of the right-angle corner of the other sub-light-transmitting region 12110.

That is, the acute angle of the sub-light-transmitting region 12110 is 45° ; one right-angle side of the sub-light-transmitting region 12110 is not parallel to the first direction, the other right-angle side is not parallel to the second direction; but in adjacent sub-light-transmitting regions 12110: the oblique side of one sub-light-transmitting region 12110 is provided in a collinear manner with the inflection point of the right-angle corner of the other sub-light-transmitting region 12110.

It is worth mentioning that the distance from each side of this sub-light-transmitting region 12110 to the corresponding edge of the main light-transmitting region 1210 is greater than or equal to 3 µ m, such as 3 µ m, 4 µ m, 5 µ m, 6 µ m, 7 µm, etc.

In the solution of the present application, since a right-angle corner is provided on the side of the compensation light-transmitting region 1211 close to the rounded corner, thus the rounded corner of the main light-transmitting region 1210 is compensated and filled to avoid the square picture from being rounded, ensure that the picture captured by the photosensitive element 20 is not distorted, and make the picture more realistically restored.

### The Third Embodiment

The third embodiment of the present application provides a display device. As shown in FIGS. 3 to 11, the display device includes the display panel 10 mentioned in the first embodiment or the second embodiment and the photosensitive element 20 corresponding to the photosensitive display region 12. This embodiment precisely adopts the photosensitive display region 12 in the first embodiment or the second embodiment, which can improve the shooting brightness of the photosensitive element 20, further improve the imaging effect of the photosensitive element 20, and expand the shooting viewing angle. and since the rounded-rectangle structure and the right-angle corner are set, the diffraction can be improved and the rounding of the square picture can be avoided, making the image captured by the photosensitive element 20 more realistic and with a higher degree of restoration.

In addition, the terms "first", "second", and "third" are only used for descriptive purposes and should not be construed as indicating or implying relative importance or implicitly specifying the quantity of the indicated technical features. Thus, the features defined with "first", "second", and "third" may explicitly or implicitly include one or more of such features. In the description of the present application, "a plurality of" means two or more, unless otherwise specifically defined.

It should be noted that "upper", "lower", "left", "right", etc. are only used for differentiation to facilitate the description and do not impose any orientation limitations on the embodiments of the present invention. For example, the "upper" may actually be the "lower", "left", "right", etc. in practice. In the present application, unless otherwise clearly defined and limited, the terms "assemble", "connect", etc. should be understood in a broad sense. For example, it can be a fixed connection, a detachable connection, or an integral connection; it can be a mechanical connection or an electrical connection; it can be a direct connection, an indirect connection through an intermediate medium, or the interaction relationship between two elements within the two components. For those skilled in the art, the specific meanings of the above terms in the present application can be understood according to specific situations.

In the description of this specification, the descriptions referring to the terms "some embodiments", "for example" and so on mean that the specific features, structures, materials or characteristics described in combination with the embodiment or example are included in at least one embodiment or example of the present application. In this specification, the schematic representations of the above terms do not necessarily refer to the same embodiment or example. Moreover, the described specific features, structures, materials or characteristics can be combined in a suitable manner in any one or more embodiments or examples. In addition, without contradiction, those skilled in the art can combine and integrate the different embodiments or examples and the features of different embodiments or examples described in this specification.

Although the embodiments of the present application have been shown and described above, it can be understood that the above embodiments are exemplary and should not be construed as limiting the present application. Those skilled in the art can make changes, modifications, substitutions and variations to the above embodiments within the scope of the present application. Therefore, any changes or modifications made according to the claims and the specification of the present application shall fall within the scope covered by the patent of the present application.

## Claims

1. A display panel, comprising a photosensitive display region corresponding to a photosensitive element;
wherein the photosensitive display region comprises a plurality of display pixel regions provided in a regular manner and light-transmitting regions located between adjacent display pixel regions;
light-transmitting regions are provided at intervals with the plurality of the display pixel regions;
wherein each light-transmitting region comprises:
a main light-transmitting region of a rounded rectangle;
a compensation light-transmitting region, formed at a rounded corner of the main light-transmitting region and having a gap with the main light-transmitting region; and
a side of the compensation light-transmitting region close to the rounded corner has a right-angle corner.

2. The display panel according to claim 1, wherein each light-transmitting region is provided around a periphery of each display pixel region, and adjacent light-transmitting regions share the compensation light-transmitting region.

3. The display panel according to claim 2, wherein the main light-transmitting region has a first straight side parallel to a first direction and a second straight side parallel to a second direction, and the first direction is perpendicular to the second direction;
wherein the compensation light-transmitting region is of right-angled rectangle, and an included angle between a straight side of the compensation light-transmitting region close to the rounded corner and the first straight side or the second straight side ranges from 30° to 60°.

4. The display panel according to claim 3, wherein the included angle between the straight side of the compensation light-transmitting region close to the rounded corner and the first straight side is 45° and the included angle between the straight side of the compensation light-transmitting region close to the rounded corner and the second straight side is 45°; and/or
a right-angle inflection point of the compensation light-transmitting region close to the first straight side is provided in a collinear manner with the first straight side, and a right-angle inflection point of the compensation light-transmitting region close to the second straight side is provided in a collinear manner with the first straight side.

5. The display panel according to claim 2, wherein the compensation light-transmitting region comprises at least two sub-light-transmitting regions;
the at least two sub-light-transmitting regions are provided at intervals, and are arranged in the same plane as and intersects with the first direction and the second direction;
wherein each sub-light-transmitting region is of right-angled triangle, an acute angle of each sub-light-transmitting region ranges from 30° to 60°, and right-angle corners of adjacent sub-light-transmitting regions are close to rounded corners of different main light-transmitting regions.

6. The display panel according to claim 5, wherein the acute angle of the sub-light-transmitting region is 45°; and/or
one right-angle side of the sub-light-transmitting region is parallel to the first direction, and another right-angle side of the sub-light-transmitting region is parallel to the second direction; and/or
in adjacent sub-light-transmitting regions: an oblique side of one sub-light-transmitting region is provided in a collinear manner with an inflection point of the right-angle corner of another sub-light-transmitting region.

7. The display panel according to claim 1, wherein the display panel comprises a substrate, and a driving circuit layer, a planarization layer, a pixel definition layer and an encapsulation layer formed on the substrate in sequence;
parts of the planarization layer, the pixel definition layer and the encapsulation layer located in the main light-transmitting region and the compensation light-transmitting region are light-transmitting parts, and a refractive index of the light-transmitting part of at least one of the planarization layer, the pixel definition layer and the encapsulation layer is greater than that of other film layers surrounding the light-transmitting part.

8. The display panel according to claim 7, wherein the display panel further comprises a shielding layer and a color resist layer formed on a side of the encapsulation layer away from the substrate;
the color resist layer comprises a plurality of color resist parts with different colors;
adjacent color resist parts are different colors, and the shielding layer is provided between adjacent color resist parts;
light-transmitting holes are formed on the parts of the planarization layer, the pixel definition layer, the encapsulation layer and the shielding layer located in the main light-transmitting region and the compensation light-transmitting region, and the light-transmitting holes are filled with light-transmitting materials;
a refractive index of the light-transmitting material in the planarization layer, the pixel definition layer and the encapsulation layer is greater than that of other film layers surrounding the light-transmitting material.

9. The display panel according to claim 1, wherein the display panel comprises a substrate, and a driving circuit layer, an organic light-emitting functional layer and an encapsulation layer formed on the substrate in sequence;
the encapsulation layer comprises a first inorganic encapsulation layer, an organic encapsulation layer and a second inorganic encapsulation layer provided in sequence; and
a convex lens is formed between the first inorganic encapsulation layer and the organic encapsulation layer and in the main light-transmitting region and the compensation light-transmitting region, and a convex surface of the convex lens is away from the organic light-emitting functional layer.

10. The display panel according to claim 1, wherein the display pixel region comprises a plurality of pixel units, and each pixel unit comprises a plurality of display sub-pixels with different colors, and different display sub-pixels are provided at intervals in a row direction.

11. The display panel according to claim 10, wherein each display sub-pixel comprises a display light-emitting diode, and the display light-emitting diode comprises a display light-emitting part, and the display light-emitting part is formed on the organic light-emitting functional layer.

12. The display panel according to claim 7, wherein the planarization layer is provided on a side of the driving circuit layer away from the substrate to planarize the driving circuit layer.

13. The display panel according to claim 7, wherein the pixel definition layer have a plurality of pixel openings provided at intervals and a pixel definition part located between adjacent pixel openings, and a surface of the pixel definition part away from the substrate is a plane.

14. The display panel according to claim 13, wherein the display light-emitting diode further comprises a display anode and a display cathode; and
the display anode is provided on a side of the display light-emitting part close to the substrate, and the display cathode is provided on a side of the display light-emitting part away from the substrate.

15. The display panel according to claim 14, wherein the display anode comprises a first conductive layer, and the first conductive layer is formed on a side of the planarization layer away from the driving circuit layer and is located between the planarization layer and the pixel definition layer.

16. The display panel according to claim 15, wherein the first conductive layer is of multi-layer structure, and the first conductive layer at least comprises a reflective layer and a high work function material layer stacked in sequence.

17. The display panel according to claim 15, wherein the number of display light-emitting parts is the same as that of pixel openings, and the display light-emitting parts correspond to the pixel openings one by one.

18. The display panel according to claim 1, wherein the display panel further comprises an encapsulation layer, and the encapsulation layer is located on a side of the display light-emitting diode away from the substrate; and
the encapsulation layer comprises a first inorganic encapsulation layer, an organic encapsulation layer and a second inorganic encapsulation layer stacked in sequence.

19. The display panel according to claim 1, wherein the display panel further comprises a shielding layer and a color resist layer formed on a second inorganic encapsulation layer;
the color resist layer comprises a plurality of color resist parts provided at intervals, and adjacent color resist parts are different colors; and
the display panel further comprises a base substrate and an anti-reflection layer, and the anti-reflection layer is provided on sides of the color resist layer and the shielding layer away from the second inorganic encapsulation layer.

20. A display device, comprising the display panel according to any one of claims 1 to 19 and a photosensitive element, and the photosensitive element corresponds to the photosensitive display region.
